# DEMANDE DE BREVET EUROPEEN

(11) **EP 0 984 497 A1**
(43) Date de publication de la demande: **08.03.2000**
(21) Numéro de dépôt: 99402171.5
(22) Date de dépôt: 02.09.1999
(51) Int. Cl.: H01L 41/04, H01L 41/18

(54) **Dispositif piezo-sensible, son procede de fabrication et sa mise en oeuvre**

(30) Priorité: 03.09.1998 FR 9811308
(71) Demandeur: Delegation Generale Pour L'Armement, 00457 Armées (FR)
(72) Inventeur: Dejugnac, Corinne, 83500 La Seyne sur Mer (FR); Scarpitta, Alain, 83200 Toulon (FR); Boisrayon, Michel, 83330 Le Beausset (FR)
(74) Mandataire: Bureau de la Propriété Industrielle DGA/DSP/SDAG/BPI

(57) **Abrégé**

L'invention concerne le domaine général des céramiques piézo-électriques et a plus particulièrement pour objet un dispositif piézo-sensible comportant un matériau piézo-sensible (7) et des moyens (9b) permettant d'appliquer, à ce matériau (7), une tension de polarisation U, caractérisé en ce que le matériau n'est piézosensible que lorsqu'une tension de polarisation lui est appliquée.

Un tel dispositif peut, par exemple, être utilisé dans les transducteurs électromécaniques mis en oeuvre dans les antennes sonar.

## Description

L'invention concerne le domaine général des céramiques piézo-électriques et a plus particulièrement pour objet un dispositif piézo-sensible à polarisation variable et réglable. Un tel dispositif peut, par exemple, être utilisé dans les capteurs, de type transducteurs électromécaniques, mis en oeuvre dans les antennes sonar. Ces transducteurs peuvent être des hydrophones, des accéléromètres, des capteurs de pression hydrostatique, de déformation, de force ou de température ou des systèmes complexes pouvant associer ces différentes fonctions. Ces dispositifs peuvent également être utilisés, dans l'air, dans des microphones, des accéléromètres, des claviers de téléscripteurs ou d'ordinateurs, des détecteurs de chaleur ou des revêtements piézochromes.

Dans tout le texte, il faut entendre par matériau piézo-sensible, un dispositif sensible à la pression et présentant des propriétés piézo-électriques et/ou piézo-résistives et/ou piézo-polaires. Aussi, un dispositif piézo-sensible sera un dispositif utilisant un tel matériau.

Il existe de nombreux matériaux piézo-électriques, notamment composites, utilisés dans l'industrie.

Ainsi, le brevet US2420864 décrit un procédé de fabrication d'un matériau piézo-électrique comportant une matrice en matière plastique et un monocristal piézo-électrique.

Les matières plastiques citées sont les celluloïdes, les acétates de celluloses, les caoutchoucs chlorés, les phénol-formaldéhydes, les résines phénols-furfurol, les acrylates, les méthacrylates et les polystyrènes, tandis que les monocristaux sont choisis parmi le sel de Seignette, la tourmaline, le saccharose et l'acide tartrique.

Ces matériaux sont conçus pour être utilisés uniquement en mode hydrostatique, c'est-à-dire en soumettant toute leur surface à la pression acoustique incidente. Toutefois, ces monocristaux ont de très faibles constantes hydrostatiques et sont donc peu efficaces.

Les monocristaux ont été progressivement remplacés par des céramiques de perovskistes, et plus particulièrement par du titane-zirconate de plomb (PZT) ou du titanate de baryum, pour la mise en oeuvre de fortes puissances d'émission. Cependant, à la réception, leur constante hydrostatique est inférieure à ceile de monocristaux tel le sulfate de lithium. Aussi, leur utilisation est limitée aux modes ne compression privilégiés appartenant aux types 33,31 ou 32.

Le brevet US74233485 décrit un matériau piézo-électrique composite constitué de poudre de céramique et de polymère. Cette poudre est un mélange fritté de titanate de plomb et d'oxyde double de fer et de bismuth dont la taille moyenne des grains est de 5 microns tandis que la part pondérale de l'oxyde double de fer et de bismuth est comprise entre 50 à 80%.

Le brevet US4407054 décrit un matériau piézo-électrique composite composé d'un pré polymère tel un mélange d'huile de ricin et d'isocyanate de ricinoléate, et un matériau piézo-électrique tel le quartz, le PZT, la tourmaline, l'acide tartrique ou le sulfate de lithium.

Enfin, le brevet US4868856 décrit un matériau piézo-électrique composite constitué d'un polymère réalisé à base de polyuréthanne et d'un matériau piézo-électrique tel l'acide tartrique, un monosaccharide, un disaccharide ou un carboxylate.

Il est aussi connu que les produits appelés "Electrets", obtenus en soumettant des cires, rendues liquides par chauffage, à un fort champ électrique au cours de leur phase de refroidissement, présentent des propriétés pyroélectriques et piézo-électriques prononcées et permanentes.

Tous ces matériaux présentent de nombreux inconvénients, notamment lorsqu'ils sont utilisés dans des hydrophones. En effet, leur polarisation ou, d'une manière plus générale, leurs propriétés piézo-électriques, sont figées à l'issue de leur fabrication et, de ce fait, leur mode de fonctionnement est unique ou spécialisé (mode hydrostatique, mode 33, 31, 15 etc.). A titre d'exemple, un composite obtenu en mélangeant des grains d'acide tartrique ou de sulfate de lithium avec une résine non encore polymérisée, puis en polarisant les grains par l'un de procédés décrits dans les brevets antérieurs ne pourra être utiiisé qu'en mode hydrostatique, et ses propriétés piézo-électriques sont, en principe, invariables ou varient lentement dans le temps.

Le brevet FR27191811 décrit un matériau dont la polarisation et, par conséquent, les propriétés piézo-électriques, ou plus généralement piézo-sensibles, peuvent varier à volonté par l'application d'un champ électrique lorsque le transducteur comprenant ce matériau, ou l'antenne comprenant les transducteurs utilisant ce matériau, est en fonctionnement. Ainsi lorsque, par exemple, une antenne présente une panne, un matériau selon l'invention permet d'y pallier en intervenant dans l'antenne. Il n'est donc pas nécessaire de procéder à ces corrections au niveau du récepteur, ce qui n'est pas toujours possible, où ce qui augmente le coût du récepteur.

Pour cela, un dispositif selon ce brevet comporte un ou plusieurs matériaux piézo-sensibles constitué d'une matrice de polymère ou de produit organique diélectrique, non piézo-électrique ou faiblement piézo-électrique, et de particules, et des moyens permettant d'appliquer, à ce ou ces matériaux, une tension de polarisation U dont la valeur est réglable.

Les dites particules, telles des fibres, des poudres ou des fragments d'objets ou de matériaux, sont, suivant les cas, piézo-électriques, faiblement piézo-électriques, voire non piézo-électriques, lesdites particules pouvant être issues, en totalité ou en partie, d'au moins un matériau biologique ou de feuilles ou de plaques de matières plastiques piézo-électriques pré polarisées dans le sens de l'épaisseur ou non pré polarisées, ou de microcristaux.

A titre d'exemple, le matériau biologique peut être choisi parmi des oligosaccharides, des homopolysaccharides, des hétéropolyssaccharides, des glycosaminoglycanes, des protéogiycanes, des terpènes, des stéroïdes, des acides aminés, des oligopeptides et des polypeptides, des protéines, des nucléotides, des acides nucléiques, de l'urée ou des scies naturelles.

Par ailleurs les cites particules peuvent être issues, en totalité ou en partie des microcristaux ou des fibres de tartrate d'ammonium, de tartrate de potassium, de tartrate de diamine éthylène, de tartrate de dipotassium, de chlorate de sodium, de bromate de socium, d'hexahydrate de sulfate de nickel, d'acide iodique, de benzophénone, de gallate de lithium hydraté, ou déshydraté, de polyvinyledifluoridène, de chrlorure de polyvinyle, de copolymère d'acétate de vinyle et de cyanide de vilinylidène, de copolymère de vinylidène et de trifluoréthylène, du fluorure de polyvinyle, de nylon, de polyacrylonitrile, du polyparaxylylène, de polybichlorométhyloxétane, de polyamide aromatique, de polysulfone, de cyanoéthylcellulose, de monosaccharides, de disaccharides, de brushite, de monétite ou de sels d'acide carboxylique.

Selon une réalisation préférentielle, la matrice de polymère ou le produit organique diélectrique, non piézo-électrique ou faiblement piézo-électrique est choisi parmi les polystyrènes, polysulfones, polycarbonates, polypropylènes, polyéthylène, téréphtalates de polyéthylène, oxydes de polyphénylène, les elastomères de polyuréthanne, les polyvinylecarbazols et les fluorures de polyvinylidène, les esters de polyacrylate ou de de polyméthacrylate, les chlorures de polyvinyle, polyvinylidènes, les polymères d'acrylonitrile ou de méthacrylonitriles, les acétates de polyvinyle, celluloïdes, acétates de cellulose, polyvinylepyrrolidones, polymères cellulosiques, phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, ou les copolymères de vinylidène et de trifluorèthylène.

L'invention concerne un matériau de nature différente de ceux décrits dans le brevet FR2719181 et présentant des propriétés piézo-sensibles. Ainsi, il apparaît une tension sinusoïdale lorsqu'on applique simultanément au matériau un champ électrique continu et une force, une pression ou une accélération sinusoïdale.

Elle a plus particulièrement pour objet un dispositif piézo-sensible comportant un matériau piézo-sensible et des moyens permettant d'appliquer, à ce matériau, une tension de polarisation, et caractérisé en ce que le matériau n'est piézosensible que lorsqu'une tension de polarisation lui est appliquée.

Ce matériau peut notamment comporter au moins un pyrophosphate d'un métal alcalin ou alcalinoterreux, tel, par exemple, du pyrophosphate de sodium, ou un pyrophosphate de sodium et de calcium, celui-ci pouvant avoir la formule Na₂OCaOP₂O₅.

Les moyens permettant d'appliquer, à ce matériau, une tension de polarisation peuvent comporter une source de tension, un amplificateur polarisateur et des électrodes et de façon avantageuse, des moyens aptes à régler la valeur de cette tension de polarisation.

L'invention a aussi pour objet un procédé de fabrication d'un matériau utilisable dans un dispositif selon l'invention, ce procédé étant caractérisé en ce qu'il consiste au moins :
- à compacter un mélange de poudres de pyrophosphate de sodium et de pyrophosphate de calcium, préférentiellement à une pression de compactage de plusieurs dizaines de mégaPascal,
- à chauffer le mélange issu du compactage, préférentiellement à une température supérieure à 650°C.

En utilisant au moins deux dispositifs selon l'invention, on peut obtenir un capteur dans lequel les matériaux piézo-électriques à polarisation variable associés fonctionnent selon des modes différents (hydrostatique, compression, cisaillement, flexion), les champs de polarisation continue ou alternative appliqués pour faire apparaître la sensibilité desdits matériaux et correspondant aux tensions de polarisation continue ou alternative, ayant soit des directions identiques, soit des directions différentes suivant les modes de fonctionnement des matériaux considérés.

D'autres avantages et caractéristiques de la présente invention apparaîtront dans la description de variantes de réalisation appliquées principalement à des hydrophones, en regard des figures annexées parmi lesquelles ;
- la figure 1 présente ces moyens de compactage utilisable pour la fabrication d'un matériau selon l'invention,
- les figures 2a à 2e présentent des moyens d'application, selon l'invention, d'une tension de polarisation U aux matériaux selon l'invention.
- les figures 3a et 3b présentent des moyens de tests de matériaux soumis à des accélérations.

Selon l'invention, un procédé de fabrication d'un matériau qui présente des propriétés piézosensibles lorsqu'une tension de polarisation lui est appliquée, peut être le suivant.

Le matériau est constitué, à la base, par un mélange de pyrophosphate de sodium de formule Na₄P₂O₇ et de pyrophosphate de calcium Ca₂P₂O₇.

La deux pyrophosphates peuvent être utilisés tels que vendus dans le commerce ou subir par exemple un traitement par l'un des procédés suivants :
- broyage, pilage, tamisage de monocristaux ou de produits inorganiques achetés sous forme d'amas cristallins ou de poudres,
- ultracentrifugation de produits inorganiques se présentant sous forme d'homogénats obtenus par broyage,
- critallisation accélérée par agitation mécanique, vibratoire ou ultrasonore d'une solution mère dans le cas de monocristaux de synthèse.

Dans cet exemple, les matériaux utilisés sont des poudres de pyrophosphates de calcium et de sodium, fournie par la Société Aldrich sous les références 32,246-6 pour le Na₄P₂O₇. La quantité de poudre de Na₄P₂O₇ utilisée est de 0,67 grammes ; la quantité de poudre de Ca₂P₂O₇ utilisée est de 0,83 grammes.

Les deux poudres de pyrophosphate de calcium et de sodium sont ensuite mélangées et broyées dans un mortier pendant 10 minutes.

Le mélange est ensuite désséché dans une étuve à 200°C sous vide à 10⁻¹ bar pendant 20 h. Cette opération est effectuée afin d'éviter tout phénomème d'adsorption de molécules d'eau.

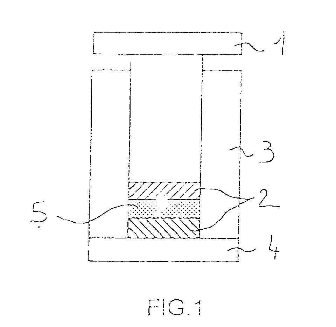

Le mélange de pyrophosphates de calcium et de sodium est ensuite placé dans un moule, comme par exemple celui présenté sur la figure 1 dans lequel une pression de 230 MPa lui est appliquée pendant cinq minutes.

Ce moule comporte principalement un piston 1, deux pièces de forme 2, un corps de presse 3 et une semelle 4.

Ce moule produit des pastilles 5 de forme cylindrique, de diamètre 1,3 mm et d'épaisseur 2 mm. Cette étape de compactage est effectuée sous atmospnère azotée afin de maintenir le mélange dans une atmosphère sèche.

La pastille 5 ainsi obtenues subit alors un traitement thermique à 850°C pendant 24 h : cette dernière étape est destinée à assurer une meilleure homogénéité au sein du mélange et à favoriser les échanges cationiques.

On place ensuite la pastille 5 entre deux électrodes circulaires et planes. Le diamètre extérieur des électrodes est de 20 mm; leur épaisseur est de 3 mm.

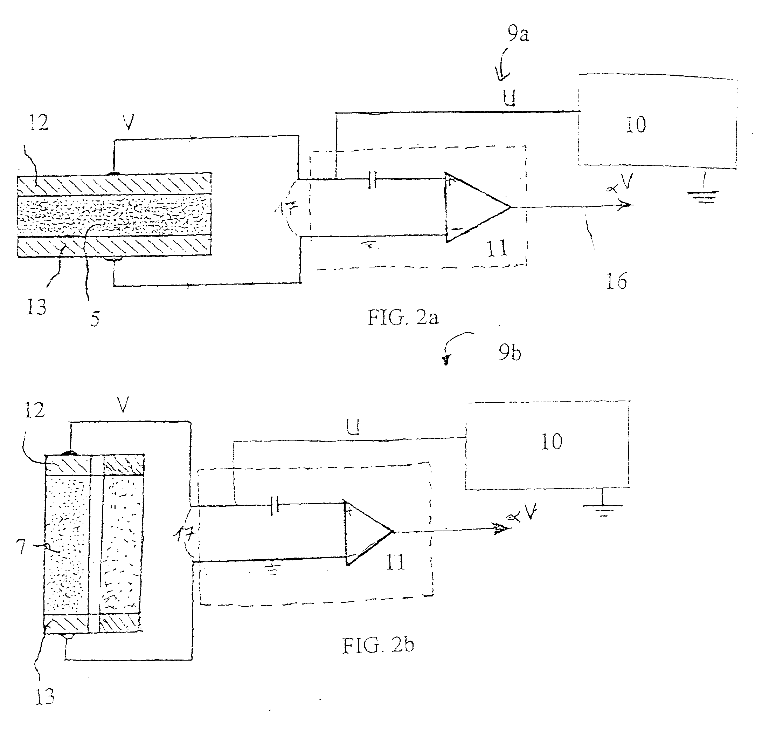

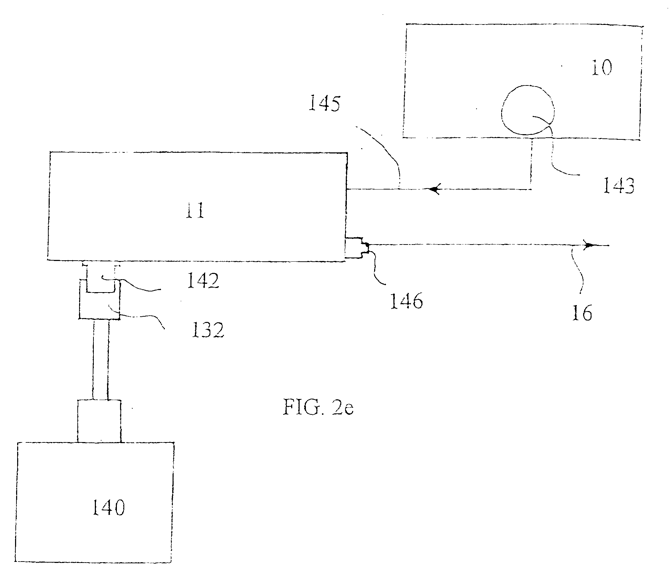

Les figures 2a et 2b montrent des moyens 9a, 9b d'application, respectivement à des disques 5 et à des tubes 7 en matériau selon l'invention, d'une tension de polarisation U.

Chacun de ces moyens 9a, 9b, comporte une source de tension 10, un amplificateur polarisateur 11 et des électrodes 12,13.

Chaque amplificateur comporte, notamment, un préamplificateur différentiel 14.

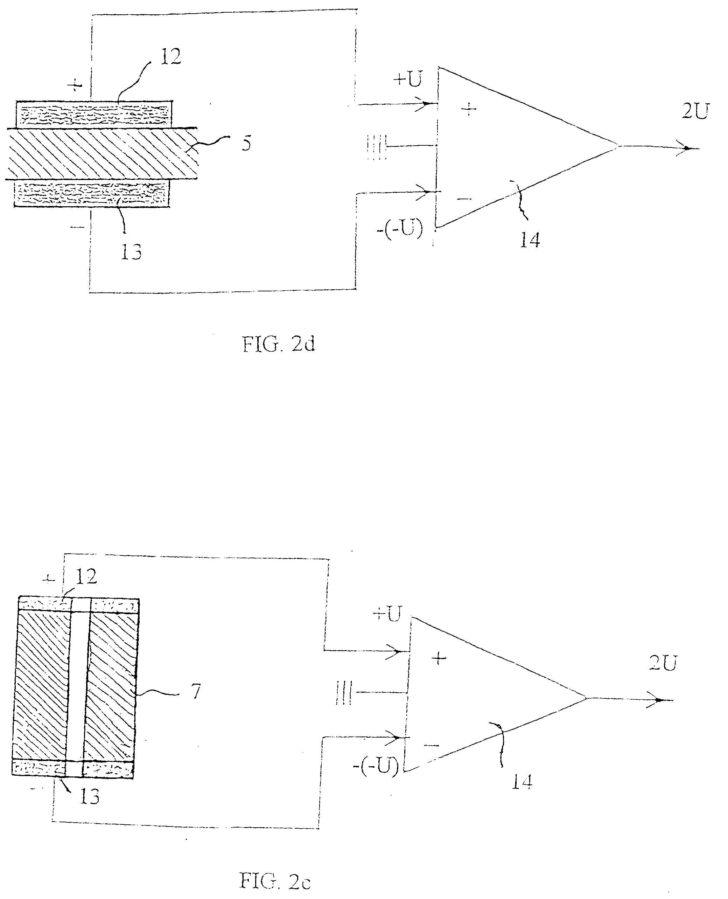

L'intérêt de ce type de montage est le suivant : les tubes 7 sont reliés à un préamplificateur différentiel comme montré sur la figure 2c, ce qui permet d'exploiter pleinement leur sensibilité hydrophonique. En revanche, les disques 5, étant reliés à un préamplificateur différentiel comme indiqué sur la figure 2d, fonctionnent en accéléromètres. On a ainsi l'exemple d'un capteur doté de deux fonctions.

La polarisation variable appliquée aux éléments sensibles crée une troisième fonction qui est la correction des dissymétries des éléments sensibles (différences de sensibilités aux pressions acoustiques) comme mentionné précédemment et la correction des défauts qui pourraient apparaître dans ces matériaux au cours du temps. On peut ainsi obtenir une véritable fonction adaptative.

Là encore, on peut faire varier la polarisation à volonté et corriger ainsi les défauts de symétrie des éléments sensibles pour mieux compenser des accélérations parasites.

Le matériau piézo-sensible est inséré entre deux électrodes métalliques 12,13 ayant la forme souhaitée pour les applications recherchées.

Ces électrodes 12,13 sont pourvues de deux fils de connexion 17 qui permettent simultanément de recueillir le signal 16 délivré par le capteur lorsqu'il est excité par une grandeur convenable (pression acoustique pour un hydrophone, accélération pour un accéléromètre, etc.), et d'appliquer la tension de polarisation, provenant de la source 10, nécessaire au fonctionnement du capteur. On notera que le signal 16 est recueilli à la sortie d'un amplificateur polarisateur 11, qui permet de séparer la tension continue de polarisation, qui peut varier de quelques volts à 3 k V, et le signal basse tension délivré par le capteur.

Comme montré sur la figure 2e, une prise 132 est reliée d'une part à un ensemble 140 constitué par les électrodes 12,13 et le matériau piézo-sensible 5, et d'autre part à un amplificateur/polarisateur 11, se présentant sous la forme d'un coffret, qui est pourvu d'une embase coaxiale 142, et qui permet en même temps de recueillir le signal délivré par l'hydrophone et de le soumettre à une tension de polarisation continue.

Cette tension peut varier, en fonction de la sensibilité que l'on désire, de 0V à 2kV. Elle est réglée par un potentiomètre 143.

L'amplificateur/polarisateur 11 est relié à une source de tension continue 10 par l'intermédiaire d'un câble 145. Le câble 145 est connecté directement à l'intérieur du coffret et ce dernier est muni d'une prise 146, qui permet de récupérer le signal basse tension délivré par l'hydrophone et amplifié dans ce coffret.

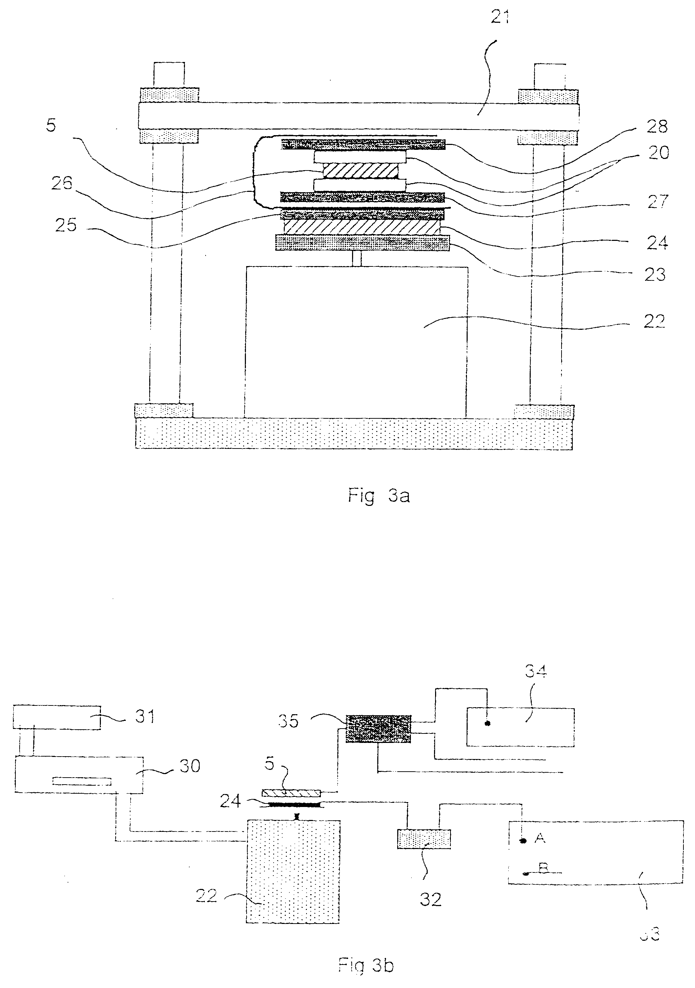

Afin de comparer les performances d'un matériau selon l'invention avec des matériaux classiques tels que des céramiques ainsi qu'avec les pyrophosphates de base pris individuellement, un ensemble pastille et électrodes de chacun de ces matériaux a été placé dans un montage sur pot vibrant comme montré sur les figures 3a et 3b.

La figure 3a présente un dispositif de tests composé d'un châssis 20 en acier cadmié, sur lequel est placé un pot vibrant Bruel et Kjaer 21 type 4809.

Sur ce pot vibrant vient se fixer un plateau en aluminium 22 de diamètre 90 mm et de 5 mm d'épaisseur.

Sur ce plateau 22 on place une céramique de type poreuse 23 électrodée, de dimensions 76 mm x 76 mm x 5 mm, puis une plaque en chlorure de polyvinyl isolante électriquement 24 puis l'extrémité d'un feuillard en polyvinyl isolante électriquement 25, puis l'extrémité d'un feuillard en cuivre 26 une seconde plaque en chlorure de polyvinyl isolante 27 puis une pastille 5 prise en sandwich entre deux électrodes 12,13 puis une troisième plaque de chlorure de polyvinyl isolante 28, enfin la deuxième extrémité du feuillard en cuivre 26.

Les mesures de sensibilité aux accélérations des matériaux comparés, sont exécutées en utilisant le dispositif représenté sur la figure 3b.

Le pot vibrant 21 est excité par un générateur de fréquences 30 type 201 S-B (ADRET électronique) couplé à un amplificateur de puissance 31, de caractéristiques 60 W-20Hz/20 KHz.

Le signal restitué par la céramique transite par un préamplificateiir 32 de gain 10 dB puis est récupéré et visualisé sur un oscilloscope classique 33. Ce signal sert de référence. La pastille 5 est excitée par de la haute tension débitée par un générateur de tension 34. Le signal électronique est restitué par un préamplificateur 35 de gain 20 dB, puis récupéré sur l'oscilloscope 33.

Les tableaux suivants fournissent la tension délivrée par le matériau et lue sur l'oscilloscope 33 lorsqu'il est soumis aux accélérations du pot vibrant 21 dans les conditions décrites précédemment. Les mesures ont été faites pour quatre valeurs de la fréquence (300 Hz, 500 Hz, 800 Hz, 1000 H), avec et sans tenson continue appliquée.

Les matériaux testés appelés NC95 et NC80 sont des matériaux selon l'invention comportant respectivement 80% et 95% de pyrophosphate de sodium. Pour leur préparation, on mélange et on broie des poudres de pyrophosphates de sodium et de calcium dans les proportions suivantes (Na₄P₂O₇)ₓ (Ca₂F₂O₇N)₁₋ₓ avec x=0,755 dans le premier cas et x=0,936 dans le deuxième.

Le mélange est ensuite desséché à 200°C pendant 20 heures puis compacté sous la forme d'une pastille sous une pression de 2,2 kbars et enfin chauffé sans air à 850°C pendant 24 heures.

**Tableau 1**

| | 300 Hz | 500 Hz | 800 Hz | 1000 Hz | |
|---|---|---|---|---|---|
| Céramique | 880 mV | 460 mV | 580 mV | 580 mV | |
| NC95 | - | - | - | - | |
| NC80 | - | - | - | - | |
| Ca2 P2 O7 | - | - | - | - | |
| Na4P2O7 | 20 mV | - | - | - | |

Le tableau 1 montre que, sans application d'une tension de polarisation, les matériaux selon l'invention, ainsi que le pryphosphate de calcium ne présentent pas de sensibilité aux accélerations. En d'autres termes, sans application d'une tension de polarisation, ils ne présentent pas de caractéristiques piézo-sensibles.

Le pyrophosphate de sodium présente quant à lui une sensibilité très faible à la fréquence de 300Hz (20mV) et la céramique possède une piézosensibilité naturelle à toutes les fréqunces testées.

**Tableau 2**

| | 300 Hz | 500 Hz | 800 Hz | 1000 Hz | |
|---|---|---|---|---|---|
| Ceramique | 900 mV | 480 mV | 560 mV | 520 mV | |
| NC95 | 5,28 V | 2,8 V | 1,8 V | 2,08 V | |
| NC80 | 3,6 V | 1,28 V | 480 mV | 640 mV | |
| Ceramique | 920 mV | 540 mV | 480 mV | 540 mV | |
| Ca2P2O7 | 640 mV | 280 mV | 300 mV | 360 mV | |
| Ceramique | 880 mV | 460 mV | 580 mV | 600 mV | |
| Na4P2O7 | 3,5 V | 880 mV | 400 mV | 400 mV | |

Le tableau 2 montre que l'application d'une tension de polarisation aux matériaux selon l'invention leur procure une piézosensibilité nettement supérieure à celle des céramiques et supérieure à celle des pryphosphates de sodium et de calcium pris isolément.

De nombreuses modification peuvent être apportées sans sortir du cadre de l'invention.

Ainsi, on peut noter que la température de chauffage du mélande de poudres de pyrophosphates de sodium et de potassium peut par exemple de 850°C pour les échantillons riches en Na₄P₂O₇ ou en Ca₂P₂O₇ car elle correspond à un domaine de coexistence de α- Na₄P₂O₇ et de liquide contenant du calcium et du sodium dans le premier cas, et de de α- Ca₂P₂O₇ et de liquide contenant du calcium et du sodium dans le second cas.

Les échantillons qui se situent au milieu du diagramme de phase du système Na₂OCaOP₂O₅, sont proches d'un eutectique et la température de chauffage peut être de l'ordre de 700°C.

Il est bien évident que l'effet de recuit dépendra de la température de chauffage.

Par ailleurs, la tension de polarisation appliquée au matériau selonl'invention peut être alternative ou continue.

## Revendications

1. Dispositif piézo-sensible comportant un matériau piézo-sensible (5 ; 7) et des moyens (9a; 9b) permettant d'appliquer, à ce matériau, une tension de polarisation U, caractérisé en ce que le matériau (5 ; 7) comporte au moins un pyrophosphate d'un métal alcalin ou alcalinoterreux.

2. Dispositif selon la revendication 1, caractérisé en ce qu'il comporte du pyrophosphate de sodium.

3. Dispositif selon l'une quelconque des revendications 1 et 2, caractérisé en ce qu'il comporte un pyrophosphate de sodium et de calcium.

4. Dispositif selon la revendication 3, caractérisé en ce que le matériau comporte un pyrophosphate de sodium et de calcium de formule Na₂OCaOP₂O₅.

5. Dispositif selon l'une quelconque des revendication 1 à 4, caractérisé en ce que les moyens (9a; 9b) permettant d'appliquer, à ce matériau, une tension de polarisation U comportent une source de tension (10), un amplificateur polarisateur (11) et des électrodes (12 ; 13).

6. Dispositif selon la revendication 5, caractérisé en ce que les moyens permettant d'appliquer, à ce matériau, une tension de polarisation U comportent des moyens aptes à régler la valeur de cette tension de polarisation.

7. Procédé de fabrication d'un matériau utilisable dans un dispositif selon les revendication 1 à 6, caractérisé en ce qu'il consiste au moins :
- à compacter un mélange de poudres de pyrophosphate de sodium et de pyrophosphate de calcium,
- à chauffer le mélange issu du compactage.

8. Procédé selon la revendication 7, caractérisé en ce que la pression de compactage est de plusieurs dizaines de mégaPascal

9. Procédé selon l'une quelconque des revendications 7 et 8, caractérisé en ce que la température de chauffage du mélange est supérieure ou égale à 650°C.

10. Dispositif selon la revendication 2, caractérisé en ce que la tension (U) appliquée au matériau est continue.
